(19) Europäisches Patentamt
European Patent Office
Office européen des brevets

(11) **EP 2 035 842 B1**

(12) # EUROPÄISCHE PATENTSCHRIFT

(45) Veröffentlichungstag und Bekanntmachung des Hinweises auf die Patenterteilung:
**08.08.2018 Patentblatt 2018/32**

(51) Int Cl.:
**G01R 27/28** (2006.01)    **G01R 35/00** (2006.01)

(21) Anmeldenummer: **07726059.4**

(22) Anmeldetag: **18.06.2007**

(86) Internationale Anmeldenummer:
**PCT/EP2007/005354**

(87) Internationale Veröffentlichungsnummer:
**WO 2008/003398 (10.01.2008 Gazette 2008/02)**

(54) **VERFAHREN ZUR DIREKTEN MESSUNG DER MIXED-MODE-STREUMATRIX MIT EINEM VEKTORIELLEN NETZWERKANALYSATOR**

METHOD FOR THE DIRECT MEASUREMENT OF THE MIXED-MODE-SCATTERING MATRIX USING A VECTOR NETWORK ANALYZER

PROCÉDÉ DE MESURE DIRECTE DE LA MATRICE DE DIFFRACTION EN MODE MIXTE AVEC UN ANALYSEUR DE RÉSEAU VECTORIEL

(84) Benannte Vertragsstaaten:
**DE FR GB**

(30) Priorität: **05.07.2006 DE 102006031045**
**22.12.2006 DE 102006061144**

(43) Veröffentlichungstag der Anmeldung:
**18.03.2009 Patentblatt 2009/12**

(73) Patentinhaber: **Rohde & Schwarz GmbH & Co. KG**
**81671 München (DE)**

(72) Erfinder: **SIMON, Jochen**
**82515 Wolfratshausen (DE)**

(74) Vertreter: **Körfer, Thomas et al**
**Mitscherlich PartmbB**
**Patent- und Rechtsanwälte**
**Sonnenstrasse 33**
**80331 München (DE)**

(56) Entgegenhaltungen:
EP-A- 1 455 197        DE-A1- 10 357 244
US-A1- 2004 201 383

- DAVID E BOCKELMAN ET AL: "Calibration and Verification of the Pure-Mode Vector Network Analyzer" IEEE TRANSACTIONS ON MICROWAVE THEORY AND TECHNIQUES, IEEE SERVICE CENTER, PISCATAWAY, NJ, US, Bd. 46, Nr. 7, Juli 1998 (1998-07), XP011037203 ISSN: 0018-9480 in der Anmeldung erwähnt

- DAVID E BOCKELMAN ET AL: "Combined Differential and Common-Mode Scattering Parameters: Theory and Simulation" IEEE TRANSACTIONS ON MICROWAVE THEORY AND TECHNIQUES, Bd. 43, Nr. 7, Juli 1995 (1995-07), XP002452336 ISSN: 0018-9480 in der Anmeldung erwähnt

- DUNSMORE J ED - THAL H (ED) INSTITUTE OF ELECTRICAL AND ELECTRONICS ENGINEERS: "New methods & non-linear measurements for active differential devices" 2003 IEEE MTT-S INTERNATIONAL MICROWAVE SYMPOSIUM DIGEST.(IMS 2003). PHILADELPHIA, PA, JUNE 8 - 13, 2003, IEEE MTT-S INTERNATIONAL MICROWAVE SYMPOSIUM, NEW YORK, NY : IEEE, US, Bd. VOL. 3 OF 3, 8. Juni 2003 (2003-06-08), Seiten 1655-1658, XP010746678 ISBN: 0-7803-7695-1

- DAVID E BOCKELMAN ET AL: "Pure-Mode Network Analyzer for On-Wafer Measurements of Mixed-Mode S-Parameters of Differential Circuits" IEEE TRANSACTIONS ON MICROWAVE THEORY AND TECHNIQUES, IEEE SERVICE CENTER, PISCATAWAY, NJ, US, Bd. 45, Nr. 7, Juli 1997 (1997-07), XP011036856 ISSN: 0018-9480

- FAN W ET AL: "Mixed-mode S-parameter characterization of differential structures" ELECTRONICS PACKAGING TECHNOLOGY, 2003 5TH CONFERENCE (EPTC 2003) DEC. 10-12, 2003, PISCATAWAY, NJ, USA,IEEE, 10. Dezember 2003 (2003-12-10), Seiten 533-537, XP010687350 ISBN: 0-7803-8205-6

- PFEIFFER U R ET AL: "Pure-Mode Network Analyzer Concept for On-Wafer Measurements of Differential Circuits at Millimeter-Wave Frequencies" IEEE TRANSACTIONS ON MICROWAVE THEORY AND TECHNIQUES, IEEE SERVICE CENTER, PISCATAWAY, NJ, US, Bd. 53, Nr. 3, März 2005 (2005-03), Seiten 934-937, XP011128141 ISSN: 0018-9480

**Beschreibung**

Die Erfindung betrifft ein Verfahren zur direkten Messung der Mixed-Mode-Streumatrix mit einem vektoriellen Netzwerkanalysator (im Folgenden auch VNA).

Zur Übertragung elektrischer Signale sind Leitungen gebräuchlich, die in der Regel zwei getrennte Leiter aufweisen. In der Vergangenheit waren diese Leitungen meist erdunsymmetrisch (unbalanciert), d.h. ein Leiter liegt auf Erd- bzw. Massepotential. Auf einer massebezogenen erdunsymmetrischen Leitung ist meist nur ein Wellenmode ausbreitungsfähig. In neuerer Zeit werden Signale aber auch zunehmend erdsymmetrisch übertragen. Bei einer erdsymmetrischen Leitung, die auch als balancierte Leitung bezeichnet wird, sind beide Leiter losgelöst vom Massepotential. Daher sind zwei Fundamentalmoden ausbreitungsfähig, nämlich der Gegentaktmode und der Gleichtaktmode. Bei dem für die Signalübertragung bevorzugten Gegentaktmode haben die auf Masse bezogenen Signalspannungen der beiden Leiter gleiche Amplitude, aber entgegengesetzte Phasen. Beim Gleichtaktmode hingegen sind nicht nur die Amplituden, sondern auch die Phasen der massebezogenen Einzelleitermoden gleich. Jeder physikalisch mögliche Wellenmode lässt sich als Linearkombination von Gegen- und Gleichtaktmode beschreiben.

Die Übertragung von Gegentaktsignalen hat gegenüber der von massebezogenen Signalen den Vorteil, dass sich einerseits evtl. auf der Masse vorhandene Störsignale nicht zum Nutzsignal addieren und damit nicht mehr von diesem getrennt werden können und dass andererseits die Leitung aufgrund ihrer Symmetrie ein geringeres Störsignalfeld abstrahlt. Mit der zunehmenden Verbreitung der Gegentaktübertragung werden vermehrt auch elektrische Bauteile mit erdsymmetrischen Toren hergestellt.

Um die elektrischen Eigenschaften von Bauteilen bei höheren Frequenzen zu messen, verwendet man üblicherweise Netzwerkanalysatoren. Die primären Messgrößen von Netzwerkanalysatoren sind Streu- (S-) Parameter, die das Transmissions- und Reflexionsverhalten eines Bauteils, das im Folgenden Messobjekt (MO) genannt wird, beschreiben. Ein vektorieller Netzwerkanalysator (VNA) liefert die S-Parameter als komplexe Größen, also mit Betrags- und Phaseninformation. Die komplexen S-Parameter lassen sich in weitere Beschreibungsparameter des MO umrechnen, wie etwa Z- bzw. Y-Parameter oder Gruppenlaufzeit.

Kommerziell erhältliche vektorielle VNA verfügen jedoch nur über erdunsymmetrische (auch: nodale) Messtore, an die die balancierten Tore eines MO nicht direkt angeschlossen werden können. Üblich ist es daher, jeden der beiden Pole eines erdsymmetrischen MO-Tors mit dem signalspannungsführenden Pol, also i.d.R. dem koaxialen Innenleiter eines erdunsymmetrischen VNA-Messtors zu verbinden. Sofern sich das MO linear verhält, kann man mit dem erdunsymmetrischen VNA die erdunsymmetrischen S-Parameter des MO messen und diese anschließend in erdsymmetrische S-Parameter umrechnen. Ein derartiges Umrechnungsverfahren ist in dem Fachaufsatz D.E. Bockelman, W.R. Eisenstadt: "Combined Differential and Common-Mode Scattering Parameters: Theory and Simulation", IEEE Transactions on Microwave Theory and Techniques, Vol. 43, No. 7, Jul. 1995, pp. 1530-1539 beschrieben. Die S-Parameter eines MO, das balancierte Tore aufweist, werden auch als Mixed-Mode-Parameter bezeichnet. Diese Bezeichnung resultiert aus der Tatsache, dass die Streumatrix eines MO mit balancierten Toren die Übertragung zwischen ein- und auslaufenden Gegentakt- und Gleichtakt-Wellen beschreibt. Kommen noch erdunsymmetrische Tore hinzu, so sind in der Mixed-Mode-S-Matrix die Übertragungsfunktionen zwischen drei verschiedenen Moden enthalten. Zum Beispiel hat die Mixed-Mode-S-Matrix $S_M$ eines Filters mit unsymmetrischem Eingang an Tor 1 und symmetrischem Ausgang an Tor 2 die nachfolgend dargestellten 9 Elemente:

$$S_M = \begin{pmatrix} S_{ss11} & S_{sd12} & S_{sc11} \\ S_{ds21} & S_{dd22} & S_{dc22} \\ S_{cs21} & S_{cd22} & S_{cc22} \end{pmatrix} \qquad (1)$$

Der Elementindex s (single ended) steht für den unsymmetrischen Mode des Tors 1, d (differential) für den Gegentakt- und c (common) für den Gleichtaktmode des Tors 2.

Aktive MO mit balancierten Toren, wie etwa Gegentaktverstärker, können ein nichtlineares Verhalten aufweisen. In diesem Fall lassen sich die Übertragungsfunktionen für Gleich- und Gegentaktwellen nicht durch lineare Superposition der Übertragungsfunktionen für erdunsymmetrische Wellen gewinnen. Vielmehr muss ein für derartige Messobjekte geeigneter VNA in der Lage sein, ein echtes erdsymmetrisches Anregungssignal (Stimulussignal) zu erzeugen. Aus der US-Offenlegungsschrift US 2004/0201383 A1 ist ein Verfahren bekannt bei dem ein VNA über einen Hybrid-Koppler an ein balanciertes MO angeschlossen wird und der Einfluss des Hybrid-Kopplers durch de-embedding berücksichtigt wird. Ein VNA für MO mit zwei balancierten Toren ist beispielsweise in der US-Patentschrift US 5,495,173 B1 offenbart. Das Messobjekt wird dort in Vor- und Rückwärtsrichtung wechselweise mit einem Gegentakt- und einem Gleichtaktgeneratorsignal gespeist. Die Erzeugung dieser Signale geschieht mit Hilfe von Hybridschaltungen. Nachteilig ist dabei, dass die Einhaltung der Amplituden- und Phasenbedingungen für reine Gegen- und Gleichtaktsignale abhängig von der Idealität der Hybridschaltungen ist. Hinreichend gute Eigenschaften lassen sich bei derartigen Schaltungen nur über einen relativ begrenzten Frequenzbereich realisieren, wobei ein Verhältnis zwischen unterer und oberer Frequenzgrenze von maximal etwa 1:8 erreichbar ist. Zudem müssen alle Schaltungskomponenten hinter den Hybriden möglichst identisches Übertragungsverhalten aufweisen, damit das eingestellte Amplituden- und Phasenverhältnis bis hin zu den Messtoren erhalten bleibt. In dem Fachaufsatz D.E. Bockelman, W.R. Eisenstadt: "Calibration and Verification of the Pure-Mode Vector Network Analyzer", IEEE Transactions on Microwave Theory and Techniques, Vol. 46, No. 7, Jul. 1998, pp. 1009-1012 ist ein Verfahren offenbart, bei dem die erdsymmetrischen Parameter mit einer nichtidealen Messvorrichtung gemäß der US 5,495,173 B1 gemessen und anschließend unter Annahme linearen Verhaltens des Messobjekts korrigiert werden. Sofern sich das MO jedoch nichtlinear verhält, ist dieses Verfahren nicht anwendbar.

Für das Problem, über einen weiten Frequenzbereich möglichst ideale Gegen- und Gleichtaktsignale zu erzeugen, bieten die US-Offenlegungsschriften US 2004/0196083 A1 und US 2004/0196051 A1 bzw. die zur US 2004/0196083 A1 korrespondierende deutsche Offenlegungsschrift DE 103 57 243 A1 eine Lösung an. Fig. 1 zeigt den Aufbau einer Dualausgang-Hochfrequenz-Signalquelle (DHSQ) nach diesem Stand der Technik. Ein Signalgenerator 101, der entweder ein eigenständiges Gerät oder aber integraler Bestandteil eines Zweitor-VNA sein kann, erzeugt ein HochfrequenzSignal. Dieses Signal wird z.B. mit Hilfe eines Signalteilers 102 in zwei Pfade aufgespaltet. In einem der beiden Pfade können Signalamplitude und -phase mit Hilfe eines Vektormodulators 112 über die I/Q-Steuereingänge 113, 114 verstellt werden. Zur Einstellung der an den Bezugsebenen 105, 106 der DHSQ gewünschten Amplituden- und Phasendifferenz werden die hin- und rücklaufenden Wellen über Koppelviertore 103, 104 und Messstellen 107 bis 110 gemessen. Gemäß der US 2004/0196051 A1 erfolgt die Kalibrierung des VNA mit einem Gleichtaktsignal, das mit Hilfe eines Signalteilers erzeugt wird. Nach der Kalibrierung des VNA wird die DHSQ in der Weise kalibriert, dass der Vektormodulator in kleinen Phaseninkrementen von z.B. nominal 1° den Bereich 0° bis 360° durchfährt. Aufgrund von Nichtidealitäten unterscheiden sich die tatsächlich erzeugten Phaseninkremente vom nominalen Wert. Die tatsächlichen Phasen werden mit Hilfe des VNA gemessen und in einer Korrekturtabelle eingetragen. Mit Hilfe der Tabelle kann dann für jede gewünschte Phasendifferenz der DHSQ ein am Vektormodulator nominal einzustellender Phasenwert zugeordnet werden.

Das offenbarte Verfahren weist mehrere Schwachpunkte auf. Zum einen ist zur Kalibrierung des VNA ein Signalteiler erforderlich. Die Qualität dieser Kalibrierung hängt also wesentlich von den Eigenschaften des Signalteilers ab. Nichtidealitäten dieses Bauteils, wie etwa Unsymmetrien, schlagen sich letztlich in Amplituden- und Phasenabweichungen des DHSQ-Signals nieder. Zudem gehört ein Signalteiler nicht zum üblichen Zubehör eines VNA und muss daher u.U. extra beschafft werden. Zum anderen berücksichtigt das offenbarte Verfahren nicht, dass ein an die DHSQ angeschlossenes Messobjekt die beiden Signalzweige der DHSQ miteinander verkoppeln und dadurch den in der Korrekturtabelle niedergelegten Zusammenhang zwischen nominaler und tatsächlicher Phasendifferenz verändern kann. Die beiden genannten Probleme werden durch das erfindungsgemäße Verfahren beseitigt.

Mit der Erzeugung eines Stimulussignals für ein balanciertes MO ist jedoch die zu lösende Aufgabe, nämlich die Bestimmung der Elemente der Mixed-Mode-Matrix, noch nicht vollständig gelöst. Es müssen auch die hin- und rücklaufenden Wellengrößen im Gegen- und Gleichtaktmode gemessen werden. Auch dies leistet das erfindungsgemäße Messverfahren.

Es ist bekannt, dass VNAs zur Messung der Streuparameter von erdunsymmetrischen MO einer Systemfehlerkalibrierung (SFK) unterzogen werden können, wodurch sich die Messunsicherheit erheblich reduziert. Ein hierfür geeignetes Verfahren ist beispielsweise in der deutschen Patentschrift DE 35 12 795 C2 offenbart. Dieses Verfahren bezieht sich auf einen Zweitor-VNA mit zwei komplexen Messstellen pro Tor. Wie in der DE 199 18 960 B4 gezeigt, lässt sich das Verfahren analog auch auf VNAs mit mehr als zwei Messstellen anwenden. Der Übersichtlichkeit halber soll im Folgenden jedoch exemplarisch von einem Zweitor-VNA ausgegangen werden.

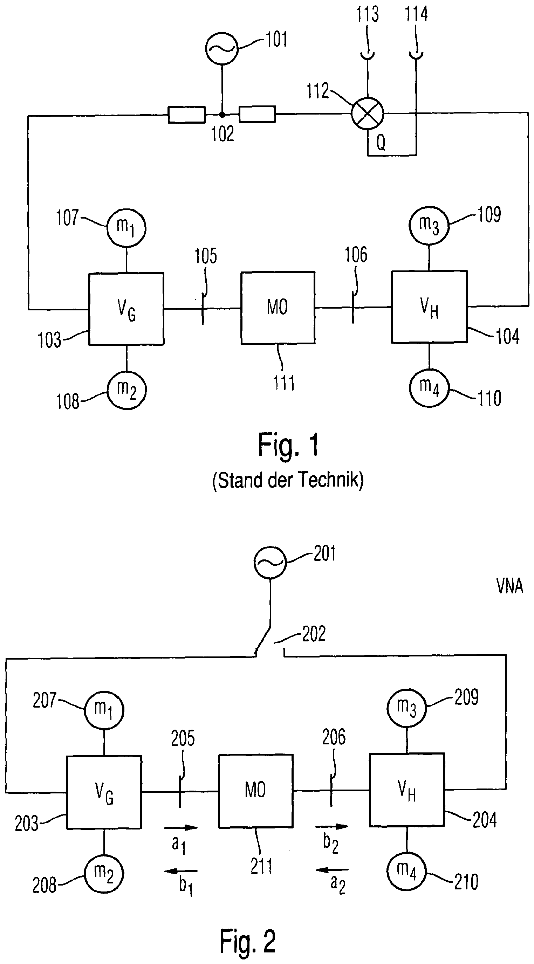

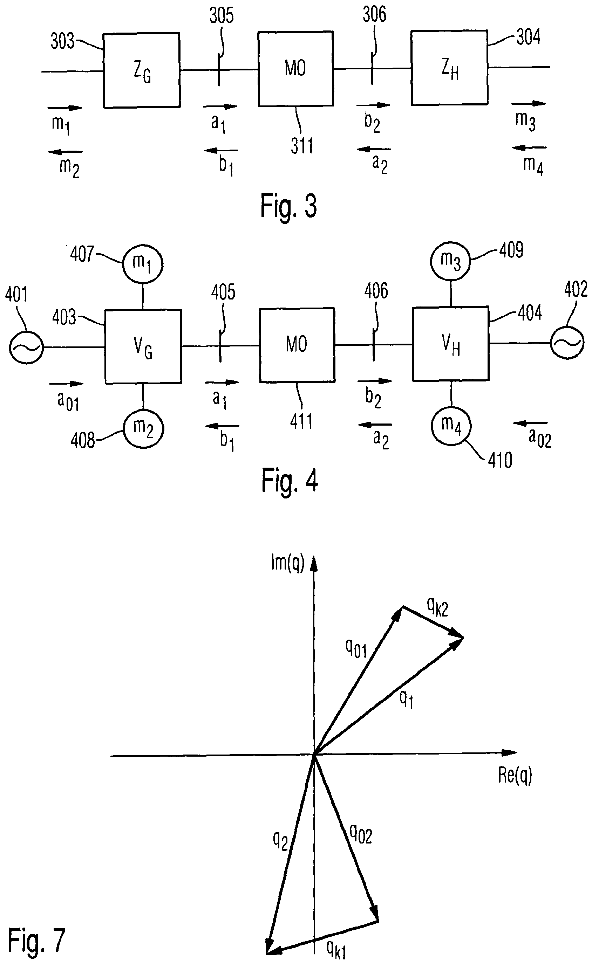

Fig. 2 zeigt den prinzipiellen Aufbau eines Zweitor-VNA mit je zwei komplexen Messstellen pro Tor. Eine Signalquelle 201 speist mit Hilfe eines Signalwegumschalters 202 wechselweise eines der Messtore 205 oder 206. Messsignale für die hin- und rücklaufenden Wellen am ersten Messtor 205 und zweiten Messtor 206 werden über die Viertore $V_G$ 203 und $V_H$ 204 ausgekoppelt und an den Messstellen 207 bis 210 gemessen. Unter der Randbedingung, dass die Empfindlichkeiten und Reflexionsfaktoren der Messstellen 207 bis 210 sowie die von den Viertoren aus gesehenen Reflexionsfaktoren des Signalwegumschalters 202 zeitinvariant und unabhängig vom Messobjekt sind, lassen sich die Viertore $V_G$ und $V_H$ - wie in Fig. 3 gezeigt - auf Zweitore $Z_G$ 303 und $Z_H$ 304 reduzieren, die sämtliche linearen Systemfehler des Zweitor-VNA repräsentieren. Die Transmissionsmatrizen dieser Fehlerzweitore verknüpfen die an den Messtoren tatsächlich vorhandenen hin- und rücklaufenden Wellen $a_1$, $b_1$ bzw. $a_2$, $b_2$ mit den vom VNA gemessenen komplexen Größen $m_1$, $m_2$, $m_3$ und $m_4$. Die Matrix G entsteht durch Zeilenvertauschung aus der Transmissionsmatrix von $Z_G$ und H durch Spaltenvertauschung aus der Transmissionsmatrix von $Z_H$. Es gelten die folgenden Zusammenhänge:

$$\begin{pmatrix} b_1 \\ a_1 \end{pmatrix} = G \begin{pmatrix} m_1 \\ m_2 \end{pmatrix} = \begin{pmatrix} G_{11} & G_{12} \\ G_{21} & G_{22} \end{pmatrix} \cdot \begin{pmatrix} m_1 \\ m_2 \end{pmatrix} \qquad (2)$$

$$\begin{pmatrix} a_2 \\ b_2 \end{pmatrix} = H \begin{pmatrix} m_3 \\ m_4 \end{pmatrix} = \begin{pmatrix} H_{11} & H_{12} \\ H_{21} & H_{22} \end{pmatrix} \cdot \begin{pmatrix} m_3 \\ m_4 \end{pmatrix} \qquad (3)$$

Für die Systemfehlerkorrektur von S-Parametern, die ja Quotienten aus Wellengrößen sind, genügen normierte Versionen der Matrizen G und H. Um die Zahl der unbekannten Fehlerterme zu reduzieren, normiert man zweckmäßigerweise auf eines der Matrixelemente, und zwar auf eines, das bei einem idealen VNA nicht zu Null wird. Hierfür bietet sich z.B. das Element $H_{21}$ an. Die Gleichungen (2) und (3) werden somit zu:

$$c \cdot \begin{pmatrix} b_1 \\ a_1 \end{pmatrix} = \begin{pmatrix} b_{1n} \\ a_{1n} \end{pmatrix} = G_n \cdot \begin{pmatrix} m_1 \\ m_2 \end{pmatrix} = \begin{pmatrix} G_{11n} & G_{12n} \\ G_{21n} & G_{22n} \end{pmatrix} \cdot \begin{pmatrix} m_1 \\ m_2 \end{pmatrix} \qquad (4)$$

$$c \cdot \begin{pmatrix} a_2 \\ b_2 \end{pmatrix} = \begin{pmatrix} a_{2n} \\ b_{2n} \end{pmatrix} = H_n \cdot \begin{pmatrix} m_3 \\ m_4 \end{pmatrix} = \begin{pmatrix} H_{11n} & H_{12n} \\ 1 & H_{22n} \end{pmatrix} \cdot \begin{pmatrix} m_3 \\ m_4 \end{pmatrix} \qquad (5)$$

wobei gilt

$$c = \frac{1}{H_{21}}$$

so dass 7 Fehlerterme verbleiben. Die Kalibrierverfahren, mit denen die Fehlerterme $G_{ijn}$ und $H_{ijn}$ durch Anschluss von ganz oder teilweise bekannten Kalibrierstandards bestimmt werden können, werden daher auch 7-Term-Verfahren genannt. Zu diesen zählen beispielsweise das TRL-, TRM-, TOM- und TNA-Verfahren.

Die Parameter $G_{ijn}$ und $H_{ijn}$ können aber auch mit Hilfe des bekannten, häufig als TOSM- oder SOLT-Verfahren bezeichneten 10-Term-Kalibrierverfahrens bestimmt werden.

Die dort erhaltenen Systemfehlerterme Transmissionsgleichlauf $T_{ji}$ von Tor i nach j sowie Reflexionsgleichlauf $RT_i$, Direktivität $D_i$ und Quelltoranpassung $SM_i$ am Tor i lassen sich über die Beziehungen

$$G_n = \frac{TT_{21}}{RT_1} \cdot \begin{pmatrix} -D_1 & 1 \\ RT_1 - D_1 \cdot SM_{11} & SM_{11} \end{pmatrix} \quad \text{und} \quad H_n = \begin{pmatrix} SM_{22} & RT_2 - D_2 \cdot SM_2 \\ 1 & -D_2 \end{pmatrix}$$

in normierte G- und H-Parameter überführen. Bei mehr als zwei Messtoren müssen dazu die 10-Term-Parameter in einheitlich normierter Form vorliegen. Dies wird z.B. durch ein Kalibrierverfahren gemäß der DE 199 18 697 A1 erreicht.

Der Erfindung liegt die Aufgabe zugrunde, ein Verfahren zur direkten Messung der Mixed-Mode-Streumatrix mit verbesserter Genauigkeit zu schaffen.

Die Aufgabe wird durch die Merkmale des Anspruchs 1 gelöst. Die Unteransprüche enthalten vorteilhafte Weiterbildungen.

Der Erfindung liegt der Gedanke zugrunde, dass zunächst eine Systemfehlerkorrektur der erdunsymmetrischen hin- und rücklaufenden Wellen zur Gewinnung korrigierter Wellen erfolgen muss und dann aus diesen korrigierten Wellen die zur Erfüllung der gewünschten Amplituden- und Phasenbedingungen in den Signalgeneratoren erforderlichen Amplituden- und Phasenänderungen berechnet und durchgeführt werden. Durch die vorgelagerte Systemfehlerkorrektur vor der Berechnung der Amplituden- und Phasenänderungen wird das Verfahren wesentlich effizienter.

Wenn die beiden unsymmetrischen Tore einer DHSQ im Netzwerkanalysator nicht über das Messobjekt miteinander verkoppelt sind, können die notwendigen Amplituden- und Phasenänderungen der Signalgeneratoren unmittelbar aus den Abweichungen der Amplituden und Phasen berechnet werden. Bei einer Verkopplung der Messtore ist die Vorgehensweise komplizierter. Dann muss für jede zu einer verkoppelten DHSQ gehörenden hinlaufenden symmetrischen Welle zunächst der komplexe Anteil ermittelt werden, dessen Betrag und Phase jeweils nur von einem der Torgruppe zugehörigen Signalgenerator abhängig ist, bevor der Gesamtvektor der insgesamt notwendigen Amplituden- und Phasenänderung, der auch die Verkopplung enthält, berechnet wird. Dabei ist eine Vorgehensweise vorteilhaft, bei welcher die Phaseneinstellungen um 180° gedreht werden und aus den dabei entstehenden Maxima und Minima die Beträge und Phasen der Teilvektoren bestimmt werden.

Die Genauigkeit der dabei gefundenen Lösung kann durch Linearisierung und Variation mittels linearen Störungsthermen entsprechend der Störungstheorie verbessert werden. Auch eine iterative Vorgehensweise ist möglich.

Ein Ausführungsbeispiel der Erfindung wird nachfolgend unter Bezugnahme auf die Zeichnung näher beschrieben. In der Zeichnung zeigen:

Fig. 1      eine Dualausgang-HF-Signalquelle nach dem Stand der Technik;

Fig. 2      den Aufbau eines Zweitor-Vektornetzwerkanalysators mit zwei komplexen Messstellen pro Tor;

Fig. 3      das Systemfehlermodell eines Zweitor-VNA nach Fig. 2;

Fig. 4      den Aufbau eines Zweitor-VNA mit zwei unabhängigen Signalquellen und zwei komplexen Messstellen pro Tor;

Fig. 5      den Zeiger der unsymmetrischen Spannungen einer unverkoppelten DHSQ vor und nach der Korrektur;

Fig. 6      den Zeitverlauf der unsymmetrischen Spannungen einer unverkoppelten DHSQ nach der Korrektur;

Fig. 7      aus Teilkomponenten zusammengesetzte komplexe Zeiger der Aufgabengrößen;

Fig. 8      den Zeiger der unsymmetrischen Spannungen einer über einen Signalteiler verkoppelten DHSQ vor und nach der Korrektur für unverkoppelte DHSQ;

Fig. 9      den Zeitverlauf der unsymmetrischen Spannungen einer über einen Signalteiler verkoppelten DHSQ nach der Korrektur für unverkoppelte DHSQ;

Fig. 10      die Ermittlung des Betragsmaximums von $q_2$;

Fig. 11      die Ermittlung der Relativphasen von $q_{01}$ und $q_{k2}$ im Zustand II;

Fig. 12      die Bestimmung des Winkels $\beta$;

Fig. 13      den Zeiger der unsymmetrischen Spannungen einer über einen Signalteiler verkoppelten DHSQ vor und nach der Hauptkorrektur sowie nach einem Nachkorrekturschritt und

Fig. 14      den Zeitverlauf der unsymmetrischen Spannungen einer über einen Signalteiler verkoppelten DHSQ nach einem Nachkorrekturschritt

Die Beziehungen (4) und (5) sowie die 7-Term-Kalibrierverfahren wurden ursprünglich zur Korrektur der Systemfehler bei Streuparametermessungen mit einem VNA entwickelt. Sie lassen sich jedoch, wie im Folgenden gezeigt, auch bei der Systemfehlerkalibrierung von Mixed-Mode-Messung anwenden.

Ein Zweitor-VNA mit zwei kohärenten Quellen lässt sich gemäß der US 2004/0196083 A1 als DHSQ zur Erzeugung von Gegen- oder Gleichtaktsignalen verwenden. Im allgemeinen Fall ist es auch möglich, ein beliebiges Amplitudenverhältnis und eine beliebige Phasendifferenz für die beiden Quellen einzustellen. Die Quellen können wie in der US 2004/0196083 A1 in der Weise realisiert sein, dass man ein gemeinsames Ursignal in zwei Pfade aufspaltet und Amplitude und Phase in einem oder beiden Pfaden mit Hilfe von Vektormodulatoren verändert. Es kann sich aber auch um zwei unabhängige Quellen handeln, die im Normalfall gleichfrequent betrieben werden und deren Kohärenz z.B. durch eine Phasenregelschleife sichergestellt ist. Wenn die Frequenz mindestens einer Quelle für eine Zeit $\Delta t$ um einen Versatz $\Delta f$ verstellt werden kann, so erlaubt dies eine definierte Drehung der Phase dieser Quelle um $\Delta f \cdot \Delta t \cdot 360°$ gegenüber der anderen.

Fig. 4 zeigt einen derartigen Zweitor-VNA. Es wird angenommen, dass Amplitude und Phase der Quelle 401 relativ zur Quelle 402 verändert werden können. Man kann die Fehlanpassung der Quellen 401 und 402 den

Koppelviertoren $V_G$ 403 und $V_H$ 404 zuschlagen. Amplitude und Phase der von den Quellen zu den Viertoren

laufenden "Ur"-Wellen $a_{01}$ und $a_{02}$ sind daher nur von den Quellen selbst abhängig und somit frei von jeder Rückwirkung der Viertore $V_G$ und $V_H$.

Auch bei diesem VNA lassen sich die Systemfehler gemäß Fig. 3 modellieren. Die Fehlerterme, d.h. die Elemente der modifizierten und normierten Transmissionsmatrizen $G_n$ und $H_n$ in (4) und (5) können also mit einem 7-Term-Kalibrierverfahren bestimmt werden. Die Kenntnis dieser Fehlerterme ermöglicht die Berechnung der aktuellen normierten unsymmetrischen Wellen $a_{1n}$ und $b_{1n}$ aus den komplexen Messwerten $m_1$ und $m_2$ bzw. der Wellen $a_{2n}$ und $b_{2n}$ aus $m_3$ und $m_4$:

$$a_{1n} = G_{21n} \cdot m_1 + G_{22n} \cdot m_2 \qquad (6)$$

$$b_{1n} = G_{11n} \cdot m_1 + G_{12n} \cdot m_2 \qquad (7)$$

$$a_{2n} = H_{11n} \cdot m_3 + H_{12n} \cdot m_4 \qquad (8)$$

$$b_{2n} = H_{21n} \cdot m_3 + H_{22n} \cdot m_4 \qquad (9)$$

Das gewünschte Amplitudenverhältnis und die gewünschte Phasendifferenz können für die zum MO hinlaufenden Wellen oder aber für die normierten Torspannungen $U_{1n}$ und $U_{2n}$ vorgegeben sein. Die Torspannungen lassen sich über den Zusammenhang $U_{in} = a_{in} + b_{in}$ aus den hin- und rücklaufenden Wellen des Tors $i$ berechnen. Es gilt:

$$U_{1n} = \left(G_{11n} + G_{21n}\right) \cdot m_1 + \left(G_{12n} + G_{22n}\right) \cdot m_2 \qquad (10)$$

$$U_{2n} = \left(H_{11n} + 1\right) \cdot m_3 + \left(H_{12n} + H_{22n}\right) \cdot m_4 \qquad (11)$$

Da sich unnormierte und normierte Wellen bzw. Spannungen nur durch einen Faktor voneinander unterscheiden, gelten die für unnormierte Größen vorgegebenen Zielwerte Amplitudenverhältnis und Phasendifferenz in gleicher Weise auch für normierte Größen. Zur Vereinfachung der Schreibweise wird daher im Folgenden der auf die Normierung verweisende Index n weggelassen. Außerdem zeigen die Gleichungen (6) bis (11), dass der lineare Zusammenhang zwischen Messgrößen einerseits und hinlaufenden Wellen bzw. Spannungen andererseits formal identisch ist. Nur die Korrekturkoeffizienten unterscheiden sich. Daher kann auf die getrennte Betrachtung von hinlaufenden Wellen und Spannungen verzichtet werden. Diese werden im Folgenden unter dem Oberbegriff Aufgabengrößen, d.h. Größen, für die ein bestimmtes $A_w$ und $\Delta\varphi_w$ eingestellt werden soll, zusammengefasst. Das Formelzeichen für diese Größen sei q.

Nach dem Einschalten befindet sich die DHSQ im Zustand I. In diesem Zustand ist das Amplitudenverhältnis

$$A_I = \left|\frac{q_{2I}}{q_{1I}}\right|$$

und die Phasendifferenz

$$\Delta\phi_I = \arg\left(q_{2I}\right) - \arg\left(q_{1I}\right) = \phi_{2I} - \phi_{1I}$$

Das gewünschte Amplitudenverhältnis ist

$$A_W = \left|\frac{q_{2w}}{q_{1w}}\right| \qquad (12)$$

und die gewünschte Phasendifferenz

$$\Delta\phi_W = \arg(q_{2W}) - \arg(q_{1W}) = \phi_{2W} - \phi_{1W} \tag{13}$$

Zur Vereinfachung wird zunächst angenommen, dass die beiden Quellen nicht über das Messobjekt miteinander verkoppelt sind. So sind die Aufgabengrößen $q_1$, $q_2$ an beiden Toren direkt proportional zu den von den jeweiligen Generatoren erzeugten "Ur"-Größen $q_{01}$ und $q_{02}$. Um vom Zustand I auf den gewünschten Endzustand zu kommen, muss die Amplitude des Signals der Quelle 401 mit dem Faktor

$$c_{01} = \frac{A_W}{A_I}$$

multipliziert und zu seiner Phase der Offset

$$\Delta\phi_{01} = \Delta\phi_W - \Delta\phi_I$$

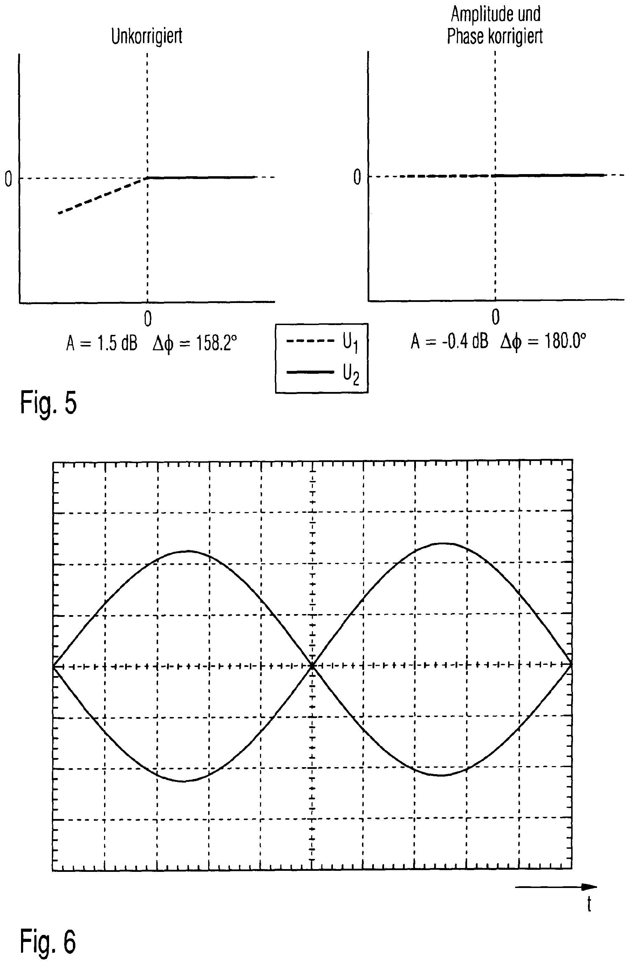

addiert werden. Fig. 5 zeigt die gemessenen unsymmetrischen Spannungszeiger $U_1$ und $U_2$ einer unverkoppelten DHSQ vor und nach der Korrektur nach dem erfindungsgemäßen Verfahren. Als Sollwerte sind $A_W = 1$ und $\Delta\varphi_W = 180°$ vorgegeben, also ein reines Gegentaktsignal. Die Signalfrequenz beträgt 100 MHz. In Fig. 6 ist der gemessene Zeitverlauf von $U_1$ und $U_2$ nach der Korrektur dargestellt.

Um Amplitudenverhältnis A und Phasendifferenz $\Delta\varphi$ der Aufgabengrößen festzustellen, ist beim erfindungsgemäßen Verfahren anders als im Stand der Technik kein Hilfsdreitor (z.B. Signalteiler) erforderlich. Es genügt eine übliche Systemfehlerkalibierung. Die Unsicherheit bei der Messung von A und $\Delta\varphi$ hängt im Wesentlichen von der Unsicherheit der Systemfehlerkorrekturdaten ab. Diese ist i.d.R. deutlich geringer als die Unsicherheit bezüglich der Symmetrie eines Signalteilers, insbesondere über einen großen Frequenzbereich hinweg. Signalteiler mit eng tolerierten Symmetrieeigenschaften sind teuer und gehören im Gegensatz zu Kalibriersätzen nicht zum Standardzubehör eines vektoriellen Netzwerkanalysators VNA. Falls über der Frequenz gesweept wird und $\Delta\varphi_I$ bei wiederholten Sweeps an jedem Messpunkt einen zunächst zufälligen Wert aufweist, ist eine Korrektur nach dem Stand der Technik völlig impraktikabel, da an jedem Messpunkt das Messobjekt MO entfernt und der Signalteiler angeschlossen werden müsste. Da beim erfindungsgemäßen Verfahren die Korrekturwerte nur einmalig aufgenommen werden müssen und die eigentliche Korrektur nur auf der Messung der aktuellen hin- und rücklaufenden Wellen der MO-Tore beruht, lässt es sich auch unter diesen erschwerten Bedingungen einsetzen.

Das beschriebene Verfahren lässt sich im Prinzip auch auf Signalquellen anwenden, die mehr als zwei unsymmetrische Ausgänge aufweisen. In der Regel ist dann die Aufgabengröße eines Tors als Referenz gegeben, auf die sich die gewünschten Amplitudenverhältnisse und Phasendifferenzen für die anderen Tore beziehen. In diesem Fall basiert die Korrektur der Wellen auf einer vorher durchgeführten einheitlich normierten Mehrtor-Systemfehlerkalibrierung.

Im allgemeinen Fall sind die Aufgabengrößen nicht voneinander unabhängig, sondern über das MO verkoppelt. Exemplarisch wird der Fall zweier verkoppelter Tore betrachtet. Wie in Fig. 7 gezeigt, setzen sich die Aufgabengrößen $q_1$ und $q_2$ aus jeweils zwei Teilvektoren zusammen. Es gilt:

$$q_1 = q_{01} + q_{k2} \tag{14}$$

und

$$q_2 = q_{02} + q_{k1} \tag{15}$$

Die Größe $q_1$ weist einen von der Quelle 401 erzeugten Anteil $q_{01}$ auf, dessen Amplitude und Phase proportional zu Amplitude und Phase der Urwelle $a_{01}$ dieser Quelle ist. Es kann jedoch auch das von der Quelle 402 erzeugte Signal über das Messobjekt 411 auf das Tor 405 überkoppeln, wo es am Viertor 403 reflektiert wird. Die Reflexion findet nur am Viertor 403 statt, da - wie bereits erwähnt - eine ideale Anpassung der Quelle 401 angenommen wird. Der von Tor 2 überkoppelnde Anteil $q_{k2}$ ist nur von Amplitude und Phase der Quelle 402 abhängig.

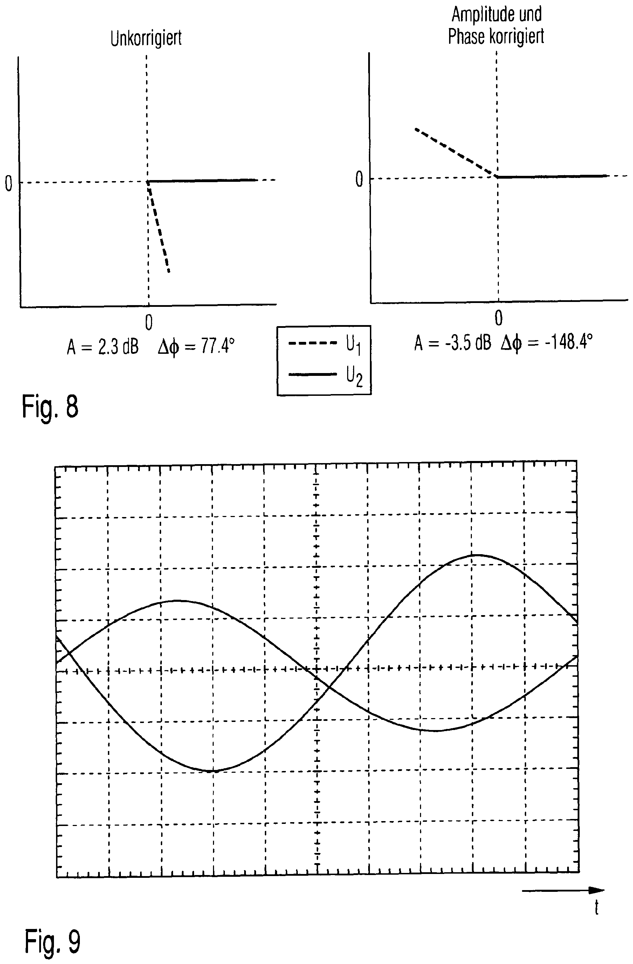

Wendet man auf eine verkoppelte DHSQ das eingangs beschriebene Verfahren für unverkoppelte DHSQ an, so erhält man in der Regel unbefriedigende Ergebnisse. In Fig. 8 sind für die Frequenz 100 MHz die gemessenen komplexen Spannungszeiger $U_1$ und $U_2$ einer über einen Signalteiler verkoppelten DHSQ dargestellt, bevor und nachdem sie nach dem oben beschriebenen Verfahren für unverkoppelte DHSQ korrigiert wurden. Frequenz sowie Zielvorgabe für Amplitude und Phase waren identisch zu Fig. 5. Wie man erkennen kann, verbleibt ein Phasenfehler von 31,6° und ein Amplitudenfehler von 3,5 dB. Auch der in Fig. 9 gezeigte Zeitverlauf der Spannungen lässt erhebliche Abweichungen vom gewünschten Gegentaktsignal erkennen.

Für verkoppelte Größen ist der Zusammenhang zwischen den gewünschten Werten $A_w$, $\Delta\varphi_w$ und der dafür notwendigen Amplituden- und Phasenänderung der Urgröße $q_{01}$ nicht so direkt ersichtlich wie für ungekoppelte. Um die erforderliche Änderung von $q_{01}$ berechnen zu können, müssen die Beträge und relativen Phasen der Teilvektoren $q_{0i}$ und $q_{ki}$ bekannt sein. Es können aber nur die Summenvektoren $q_1$ und $q_2$ direkt gemessen werden. Ein mögliches Verfahren zur Bestimmung der Vektoren $q_{0i}$ und $q_{ki}$ gliedert sich in folgende Schritte:

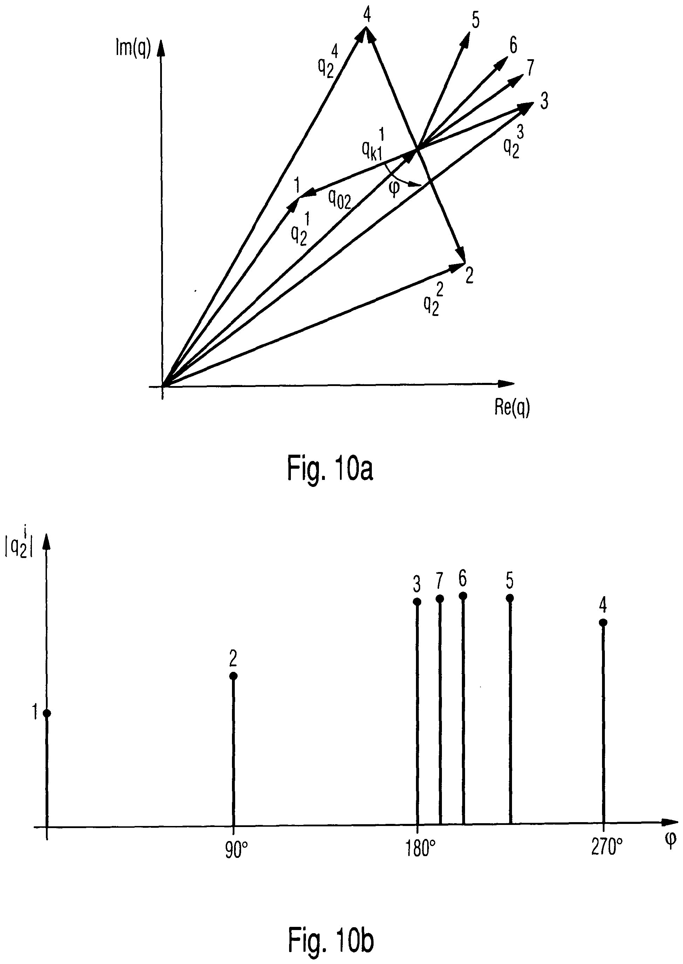

1. Ausgehend von einem Anfangszustand I mit beliebiger und unbekannter relativer Phasenlage der Vektoren $q_{02}$ und $q_{k1}$ wird die Phase $\varphi_{01}$ der Urgröße $q_{01}$ so eingestellt, dass der Betrag des Summenvektors $q_2$ im Zwischenzustand II den Maximalwert $|q_2|_{max}$ annimmt. Eine mögliche Vorgehensweise lässt sich an Hand von Fig. 10 erläutern. Die Phase des überkoppelnden Teilvektors $q_{k1}$ unterscheidet sich nur um einen konstanten Differenzwinkel von $\varphi_{01}$. Mit 4 Messungen 1...4, wobei $q_{k1}$ jeweils in Schritten von 90° auf $q_{k1}{}^{<1>}$... $q_{k1}{}^{<4>}$ gedreht wird, kann man den Quadranten des Maximums ermitteln. Innerhalb dieses Quadranten lässt sich dann über eine Intervallschachtelung die genaue Phase $\varphi_{01m}$ des Betragsmaximums feststellen. In Fig. 10a sind die Vektoren $q_{02}$, $q_{k1}{}^i$ und die resultierenden $q_2{}^i$, in 10b die gemessenen Beträge $|q_2{}^i|$ für 7 Messungen eingezeichnet, von denen 4 Quadrantenmessungen und 3 Iterationsschritte sind. Dreht man $q_{01}$ ausgehend vom Zustand II des Betragsmaximums $|q_2|_{max}$ um 180°, so erhält man das Betragsminimum $|q_2|_{min}$. Damit lassen sich die Beträge der Teilvektoren von $q_2$ bestimmen:

$$|q_{02}| = \frac{(|q_2|)_{max} + (|q_2|)_{min}}{2}$$

$$|q_{k1}| = \frac{(|q_2|)_{max} - (|q_2|)_{min}}{2}$$

Anschließend wird der Zustand II durch eine erneute Drehung um 180° wieder hergestellt.

2. Nach demselben Verfahren erfolgt die Suche nach dem Zustand III, in dem $|q_1|$ maximal wird. Dabei werden die Änderungen von $\varphi_{01}$ aufsummiert, woraus die Phasendifferenz $\Delta\varphi_{01m}$ zum Zustand II resultiert. Im Zustand III können - wiederum mit Hilfe eines 180°-Phasenoffsets - die Beträge der Teilvektoren von $q_1$ bestimmt werden:

$$|q_{01}| = \frac{(|q_1|)_{max} + (|q_1|)_{min}}{2} \qquad (16)$$

$$|q_{k2}| = \frac{(|q_1|)_{max} - (|q_1|)_{min}}{2} \qquad (17)$$

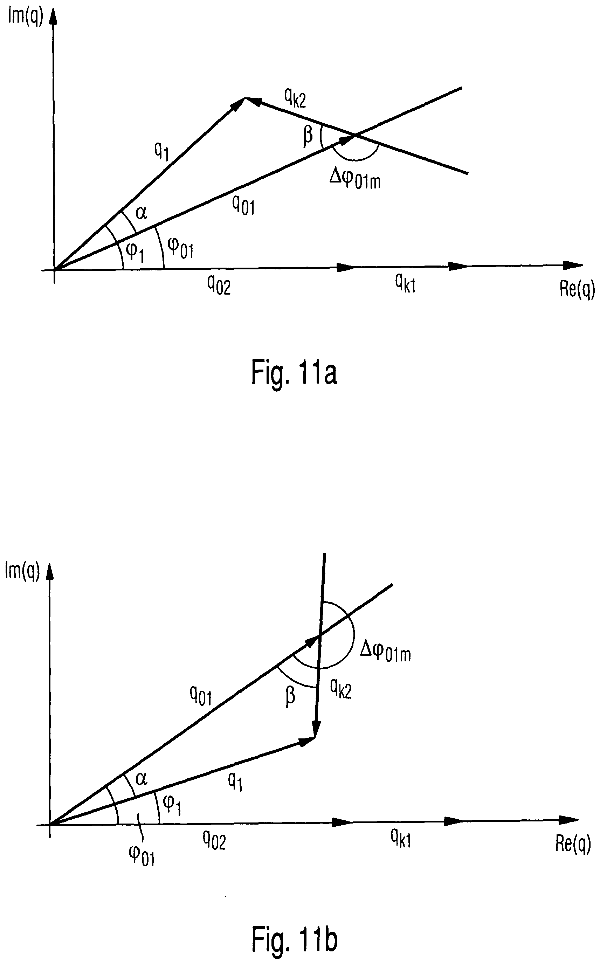

3. Die noch fehlenden Relativphasen der Teilvektoren zueinander brauchen nur für einen beliebigen Überlagerungszustand ermittelt zu werden. Da $q_{01}$ und $q_{k1}$ phasengekoppelt sind, lassen sich dann auch alle anderen möglichen Zustände berechnen. Für die Phasenbestimmung bietet sich der Zustand II an, da im Maximum von $|q_2|$ die Phasendifferenz von $q_{02}$ und $q_{k1}$ 0° beträgt und somit bereits bekannt ist. Die Teilvektoren sind in Fig. 11 dargestellt. Absolute Phasen sind nicht relevant, daher kann $\varphi_{02} = \varphi_{k2} = 0°$ gesetzt werden. $\Delta\varphi_{01m}$ aus dem 1. Schritt ist der Winkel, um den $q_{01}$ in positivem Sinne gedreht werden muss, um in dieselbe Richtung wie $q_{k2}$ zu weisen. Unter dieser Bedingung wird $|q_1|$ maximal. $\Delta\varphi_{01m}$ kann entweder, wie in Fig. 11a dargestellt, kleiner als 180°, oder aber, wie in 11b, größer als 180° sein. Der Winkel $\beta$ in dem von $q_1$, $q_{01}$ und $q_{k2}$ aufgespannten Dreieck beträgt im Fall a) 180° - $\Delta\varphi_{01m}$, im Fall b) $\Delta\varphi_{01m}$ - 180°. Da die Beträge der Vektoren $q_1$, $q_{01}$ und $q_{k2}$ aus der Messung bzw. aus dem 1. Schritt bekannt sind, lässt sich damit auch der Dreieckswinkel $\alpha$ zwischen $q_1$ und $q_{01}$ mit Hilfe des Sinussatzes berechnen:

$$\alpha = \arcsin\left(\frac{|q_{k2}|}{|q_1|} \cdot \sin(\beta)\right) \qquad (18)$$

Betrachtet man den Winkel $\alpha$ als vorzeichenbehaftete Phasendifferenz $\alpha = \varphi_1 - \varphi_{01}$, so wird sein Wert im Fall b) negativ. Wenn man keine Fallunterscheidung einführen möchte, erfordert (18) dann ein ebenfalls negatives $\beta$. Dies lässt sich mit der generell gültigen Festlegung

$$\beta = 180° - \Delta\phi_{01m} \qquad (19)$$

erreichen. Für die noch gesuchten Phasen der Teilvektoren $q_{01}$ und $q_{k2}$ gilt dann:

$$\phi_{01} = \phi_1 - \alpha$$

$$\phi_{k2} = \phi_{01} + \Delta\phi_{01m}$$

Damit sind alle Teilvektoren $q_{0i}$ und $q_{ki}$ nach Betrag und Phase bestimmt.

Es besteht nun die Aufgabe, für den Vektor $q_{01}$ den Amplitudenfaktor $c_{01}$ und die Phasenänderung $\Delta\varphi_{01}$ zu ermitteln, unter denen die durch Zusammenfassung von (12) und (13) erhaltene Bedingung

$$q_{2w} = A_w \cdot e^{j\cdot\Delta\phi_w} \cdot q_{1w} \qquad (20)$$

erfüllt ist. $c_{01}$ und $\Delta\varphi_{01}$ wirken auf die überkoppelnde Größe $q_{k1}$ in gleicher Weise wie auf $q_{01}$, so dass - ausgehend vom Anfangszustand I - für $q_{1w}$ und $q_{2w}$ angesetzt werden kann:

$$q_{1w} = c_{01} \cdot e^{j\cdot\Delta\phi_{01}} \cdot q_{01I} + q_{k2I} \qquad (21)$$

$$q_{2w} = q_{02I} + c_{01} \cdot e^{j\cdot\Delta\phi_{01}} \cdot q_{k1I} \qquad (22)$$

Der Index I wird aus Vereinfachungsgründen im Folgenden weggelassen. Durch Einsetzen von (21) und (22) in (20) erhält man:

$$q_{02} + c_{01} \cdot e^{j\cdot\Delta\phi_{01}} \cdot q_{k1} = A_w \cdot e^{j\cdot\Delta\phi_w} \cdot \left(c_{01} \cdot e^{j\cdot\Delta\phi_{01}} \cdot q_{01} + q_{k2}\right) \qquad (23)$$

Für Real- und Imaginärteil der komplexen Gl. (23) lässt sich jeweils eine skalare Gleichung formulieren. Mit den Substitutionen

$$A = A_w \cdot \left(\sin(\Delta\phi_w) \cdot \text{Im}(q_{01}) - \cos(\Delta\phi_w) \cdot \text{Re}(q_{01})\right) + \text{Re}(q_{k1})$$

$$B = A_w \cdot \left(\cos(\Delta\phi_w) \cdot \text{Im}(q_{01}) + \sin(\Delta\phi_w) \cdot \text{Re}(q_{01})\right) - \text{Im}(q_{k1})$$

$$C = A_w \cdot \left(\cos(\Delta\phi_w) \cdot \text{Re}(q_{k2}) - \sin(\Delta\phi_w) \cdot \text{Im}(q_{k2})\right) - \text{Re}(q_{02})$$

$$D = A_W \cdot \left( \cos\left(\Delta\phi_W\right) \cdot \mathrm{Im}(q_{k2}) + \sin\left(\Delta\phi_W\right) \cdot \mathrm{Re}(q_{k2}) \right) - \mathrm{Im}(q_{02})$$

können diese beiden skalaren Gleichungen nach dem gesuchten $c_{01}$ aufgelöst werden:

$$c_{01} = \frac{C}{\cos\left(\Delta\phi_{01}\right) \cdot A + \sin\left(\Delta\phi_{01}\right) \cdot B} \tag{24}$$

$$c_{01} = \frac{D}{-\cos\left(\Delta\phi_{01}\right) \cdot B + \sin\left(\Delta\phi_{01}\right) \cdot A} \tag{25}$$

Durch Gleichsetzen von (24) und (25) wird $c_{01}$ eliminiert und man erhält eine Beziehung für das ebenfalls gesuchte $\Delta\varphi_{01}$:

$$\tan\left(\Delta\phi_{01}\right) = \frac{\dfrac{A}{C} + \dfrac{B}{D}}{\dfrac{A}{D} - \dfrac{B}{C}} = \frac{A \cdot D + B \cdot C}{A \cdot C - B \cdot D} \tag{26}$$

Mit (24) oder (25) lässt sich dann auch $c_{01}$ bestimmen. Es sei darauf hingewiesen, dass (26) zwei Lösungen für $\Delta\varphi_{01}$ liefert, die sich um 180° unterscheiden. Die Betrachtung von (24) und (25) zeigt jedoch, dass $\Delta\varphi_{01}$ und $-\Delta\varphi_{01}$ zu Lösungen für $c_{01}$ führen, die sich ebenfalls lediglich im Vorzeichen unterscheiden, d.h. beide Lösungen sind äquivalent. Die Einstellung von $c_{01}$ und $\Delta\varphi_{01}$ an der Quelle 401 wird im Folgenden als Hauptkorrektur bezeichnet.

Bei einem realen VNA können bei der Einstellung von Generatorpegel und -phase Nichtlinearitäten auftreten. Zudem bewirkt die Dämpfungsänderung des Pegelstellglieds häufig auch eine Phasenänderung des Generatorsignals. Man muss also damit rechnen, dass das Generatorsignal nach der Hauptkorrektur noch nicht ganz den Erfordernissen entspricht. Sofern jedoch die Abweichungen gering sind, kann über eine linearisierte Nachkorrektur eine weitere Verbesserung erzielt werden. Der Mess- und damit Zeitaufwand für diese Nachkorrektur ist erheblich geringer, als wenn ein weiterer iterativer Hauptkorrekturschritt durchgeführt werden würde.

Mit den totalen Differentialen von $|q_1|$, $|q_2|$, $\varphi_1$ und $\varphi_2$ nach der Amplitudenänderung $\Delta q_{01}$ und der Phasenänderung $\Delta\varphi_{01}$ kann man lineare Störungsansätze für diese Größen in die Gleichungen (12) und (13) einsetzen. Man erhält das Gleichungssystem

$$\begin{pmatrix} A_W \cdot D_{11} - D_{21} & A_W \cdot D_{12} - D_{22} \\ D_{13} - D_{23} & D_{14} - D_{24} \end{pmatrix} \cdot \begin{pmatrix} \Delta q_{01} \\ \Delta\phi_{01} \end{pmatrix} = \begin{pmatrix} |q_2| - A_W \cdot |q_1| \\ \phi_2 - \phi_1 - \Delta\phi_W \end{pmatrix} \tag{27}$$

$|q_1|$, $|q_2|$, $\varphi_1$ und $\varphi_2$ stehen in Gleichung (27) für die nach der Hauptkorrektur erhaltenen Werte. Um die partiellen Ableitungen $D_{ij}$ dieser Größen nach $|q_{01}|$ bzw. $\varphi_{01}$ angeben zu können, muss man $|q_1|$, $|q_2|$, $\varphi_1$ und $\varphi_2$ zunächst als Funktionen von $|q_{01}|$ bzw. $\varphi_{01}$ darstellen.

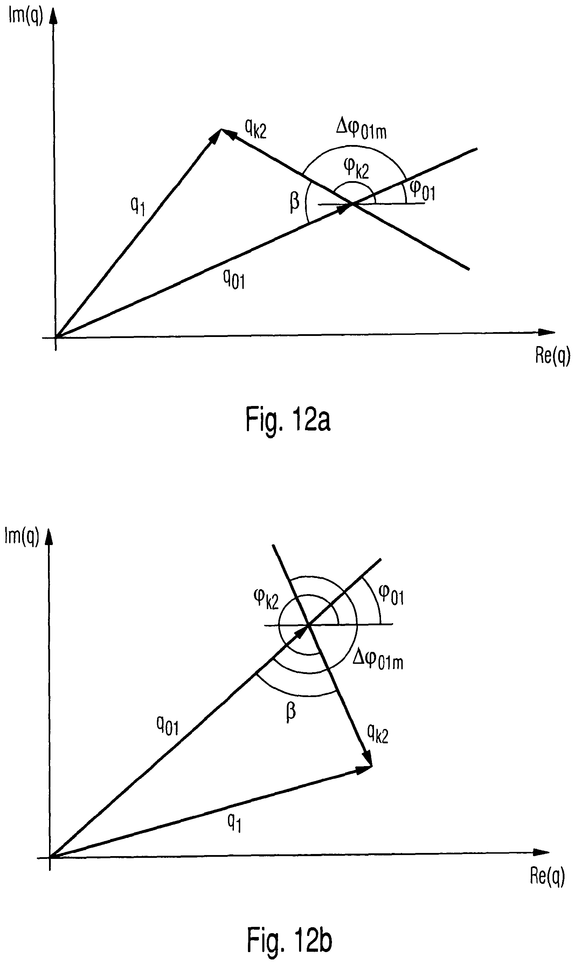

Mit dem Kosinussatz gilt für $|q_1|$ (siehe Fig. 12):

$$|q_1| = \sqrt{\left(|q_{01}|\right)^2 + \left(|q_{k2}|\right)^2 - 2 \cdot |q_{01}| \cdot |q_{k2}| \cdot \cos(\beta)} \tag{28}$$

Setzt man die aus den Gleichungen (12a) und (12b) ersichtliche Winkelbeziehung

$$\Delta\phi_{01m} = \phi_{k2} - \phi_{01}$$

in (19) ein, so wird (28) zu

$$|q_1| = \sqrt{(|q_{01}|)^2 + (|q_{k2}|)^2 - 2 \cdot |q_{01}| \cdot |q_{k2}| \cdot \cos(\pi - \phi_{k2} + \phi_{01})} \qquad (29)$$

Für die Phase von $q_1$ gilt:

$$\phi_1 = \operatorname{atan}\left(\frac{|q_{01}| \cdot \sin(\phi_{01}) + |q_{k2}| \cdot \sin(\phi_{k2})}{|q_{01}| \cdot \cos(\phi_{01}) + |q_{k2}| \cdot \cos(\phi_{k2})}\right) \qquad (30)$$

Entsprechend lässt sich für Betrag und Phase von $q_2$ angeben:

$$|q_2| = \sqrt{(|q_{02}|)^2 + (|q_{k1}|)^2 - 2 \cdot |q_{02}| \cdot |q_{k1}| \cdot \cos(\pi - \phi_{k1} + \phi_{02})} \qquad (31)$$

$$\phi_2 = \operatorname{atan}\left(\frac{|q_{02}| \cdot \sin(\phi_{02}) + |q_{k1}| \cdot \sin(\phi_{k1})}{|q_{02}| \cdot \cos(\phi_{02}) + |q_{k1}| \cdot \cos(\phi_{k1})}\right) \qquad (32)$$

Aus (29)... (32) kann man nun die partiellen Ableitungen $D_{ij}$ berechnen:

$$D_{11} = \frac{|q_{01}| - |q_{k2}| \cdot \cos(\phi_{01} - \phi_{k2} - \pi)}{|q_1|}$$

$$D_{12} = \frac{|q_{01}| \cdot |q_{k2}| \cdot \sin(\phi_{01} - \phi_{k2} - \pi)}{|q_1|}$$

$$D_{13} = \frac{N_1 \cdot \sin(\phi_{01}) - Z_1 \cdot \cos(\phi_{01})}{N_1^2 + Z_1^2}$$

$$D_{14} = |q_{01}| \cdot \frac{N_1 \cdot \cos(\phi_{01}) + Z_1 \cdot \sin(\phi_{01})}{N_1^2 + Z_1^2}$$

$$D_{21} = \frac{|q_{k1}|}{|q_{01}|} \cdot \frac{|q_{k1}| - |q_{02}| \cdot \cos(\phi_{02} - \phi_{k1} - \pi)}{|q_2|}$$

$$D_{22} = -\frac{|q_{02}| \cdot |q_{k1}| \cdot \sin(\phi_{02} - \phi_{k1} - \pi)}{|q_2|}$$

$$D_{23} = \frac{|q_{k1}|}{|q_{01}|} \cdot \frac{N_2 \cdot \sin(\phi_{k1}) - Z_2 \cdot \cos(\phi_{k1})}{N_2{}^2 + Z_2{}^2}$$

$$D_{24} = |q_{k1}| \cdot \frac{N_2 \cdot \cos(\phi_{k1}) + Z_2 \cdot \sin(\phi_{k1})}{N_2{}^2 + Z_2{}^2}$$

Gleichung (27) lässt sich z.B. mit Hilfe einer Matrixinversion nach den gesuchten Nachkorrekturwerten $\Delta q_{01}$ und $\Delta\varphi_{01}$ auflösen. Sollte die gewünschte Amplituden- und Phasenbedingung nach einem Nachkorrekturschritt noch nicht ausreichend gut erfüllt sein, kann über mehrere Nachkorrekturschritte iteriert werden.

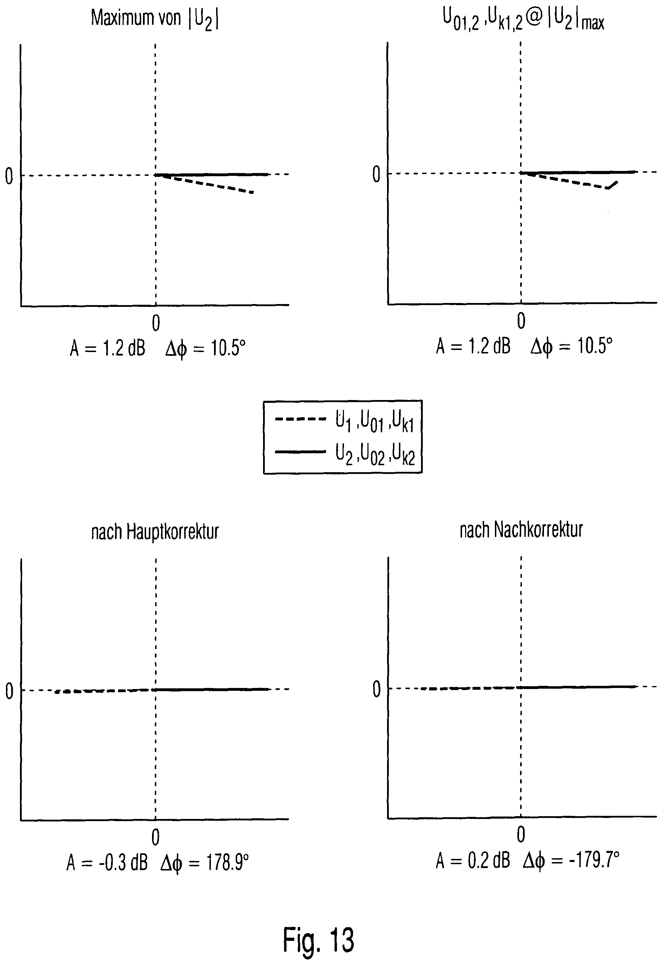

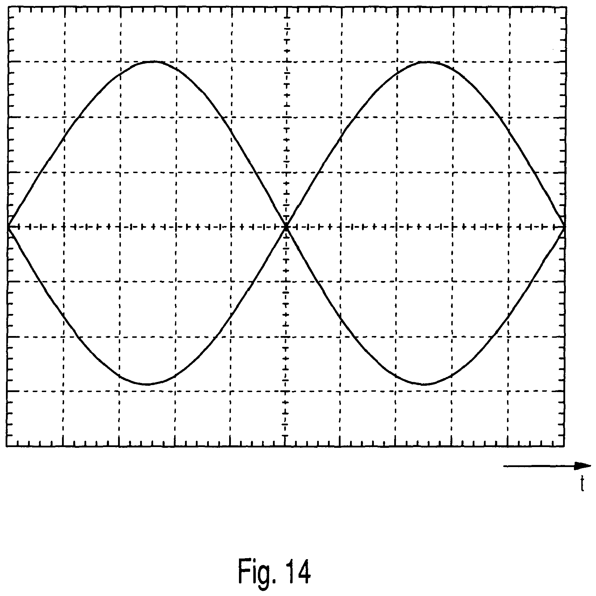

Fig. 13 zeigt die gemessenen Zeiger der unsymmetrischen Spannungen $U_1$ und $U_2$ einer über einen Signalteiler verkoppelten DHSQ vor der Korrektur (Summenvektoren und Aufspaltung in Teilvektoren), nach der Hauptkorrektur sowie nach der Nachkorrektur. Die Randbedingungen, also Signalfrequenz, Amplituden- und Phasenwertvorgabe sowie Verkopplung der DHSQ über einen Signalteiler, sind dieselben wie für Fig. 8, die Abweichungen sind mit 0,2 dB in der Amplitude und 0,3° in der Phase jedoch deutlich geringer als dort. Dies ist auch aus dem gemessenen Zeitverlauf der Spannungen $U_1$, $U_2$ in Fig. 14 ersichtlich.

Mit der Erzeugung eines reinen Gegen- bzw. Gleichtakt-Stimulussignals ist der erste Teil der in der Bestimmung der Mixed-Mode-S-Matrix $S_M$ bestehenden Messaufgabe gelöst. Es fehlt jedoch noch die Berechnung von $S_M$ aus den mit diesen Stimulussignalen ermittelten Messwerten. Die m unsymmetrischen Tore des MO seien n logischen Toren zugewiesen, wobei ein logisches Tor balanciert oder unbalanciert sein kann. In jedem Fall gilt $n \le m$. Für die Matrix $S_M$ gilt:

$$\vec{b}_M = S_M \cdot \vec{a}_M \tag{33}$$

wobei die Vektoren $\vec{b}_M$ der vom MO weglaufenden und $\vec{a}_M$ der zum MO hinlaufenden Wellen gemischtmodig sind, d.h. sowohl unsymmetrische als auch Gegen- und Gleichtaktwellen enthalten können. Die unsymmetrischen systemfehlerkorrigierten Wellen sind durch die Gleichungen (6) bis (9) gegeben. Für die hin- und rücklaufenden Gegentaktwellen eines aus den unsymmetrischen Toren j, k = 1...m bestehenden balancierten Tors mit dem Index i = 1...n gilt:

$$a_{id} = \frac{1}{\sqrt{2}} \cdot (a_j - a_k) \qquad\qquad b_{id} = \frac{1}{\sqrt{2}} \cdot (b_j - b_k)$$

und für die Gleichtaktwellen:

$$a_{ic} = \frac{1}{\sqrt{2}} \cdot (a_j + a_k) \qquad\qquad b_{ic} = \frac{1}{\sqrt{2}} \cdot (b_j + b_k)$$

Man kann für einen bestimmten Stimuluszustand p, bei dem an ein oder mehrere logische Messtore dem Tortyp entsprechende Generatorsignale (unsymmetrisch, Gleich- oder Gegentakt) angelegt werden, systemfehlerkorrigierte Wellenvektoren $\vec{a}_{Mp}$ und $\vec{b}_{Mp}$ messen. Aus m unterschiedlichen Stimuluszuständen, wobei jedes Tor mindestens einmal mit jedem diesem Tor zugehörigen Wellenmode angeregt werden muss, erhält man m korrigierte Wellenvektoren. Im einfachsten Fall wird in jedem Stimuluszustand genau ein Wellenmode an einem Tor angeregt. Ordnet man die Vektoren $\vec{a}_{Mp}$ und $\vec{b}_{Mp}$ in Matrizen an:

$$A_M = \begin{pmatrix} \vec{a}_{M1} & \vec{a}_{M2} & .. & \vec{a}_{Mm} \end{pmatrix} \qquad B_M = \begin{pmatrix} \vec{b}_{M1} & \vec{b}_{M2} & .. & \vec{b}_{Mm} \end{pmatrix}$$

so ergibt sich mit (33):

$$B_M = S_M \cdot A_M$$

Daraus kann schließlich die gesuchte Matrix $S_M$ berechnet werden:

$$S_M = B_M \cdot A_M^{-1}$$

Die Erfindung ist nicht auf das beschriebene Ausführungsbeispiel beschränkt. Außer der Spannung können auch andere Aufgabengrößen verwendet werden.

**Patentansprüche**

1. Verfahren zum Anregen und Messen von Torgruppen eines Mehrtor-Messobjekts (MO) mittels eines vektoriellen Netzwerkanalysators (VNA), wobei die Torgruppen mit gleichfrequenten und kohärenten hinlaufenden Wellen ($a_1$, $a_2$), die innerhalb jeder Torgruppe definierte Amplitudenverhältnisse und Phasendifferenzen aufweisen, angeregt werden, wobei der Netzwerkanalysator (VNA) erdunsymmetrische Messtore (405, 406) hat, und wobei die Wellen von je einem Signalgenerator (401, 402) des vektoriellen Netzwerkanalysators (VNA) pro Messtor (405, 406) generiert werden, wobei eine Systemfehlerkorrektur der erdunsymmetrischen hin- und rücklaufenden Wellen ($a_1$, $b_1$, $a_2$, $b_2$) bezüglich der Tore des Messobjekts (MO) zur Gewinnung korrigierter Wellen erfolgt, aus diesen korrigierten Wellen die zur Erfüllung der gewünschten Amplituden- und Phasenbedingungen in den Signalgeneratoren (401, 402) erforderlichen Amplituden- und Phasenänderungen berechnet werden, wobei die Messtore (405, 406) mindestens innerhalb einer Torgruppe des Messobjekts (MO) miteinander verkoppelt sind, wobei zunächst für jede zu einer Torgruppe gehörende hinlaufende unsymmetrische Welle ($a_1$; $a_2$) die Anteile als Teilvektoren ($q_{01}$; $q_{02}$) ermittelt werden, deren Betrag und Phase jeweils nur von einem der Torgruppe zugeordneten Signalgeneratoren (401; 402) abhängig ist, wobei aus diesen Teilvektoren ($q_{01}$, $q_{02}$) die zur Erfüllung der gewünschten Amplituden- und Phasenbedingungen insgesamt notwendigen Amplituden- und Phasenänderungen aller der Torgruppe zugeordneten Signalgeneratoren jeweils als Gesamtvektor ($q_1$, $q_2$) berechnet werden, wobei eine Torgruppe aus zwei unsymmetrischen Toren i und j des Messobjekts (MO) besteht und zur Ermittlung der Teilvektoren ($q_{01}$, $q_{02}$) die Phase $\varphi_i$ des Signalgenerators von Tor i gegenüber der von Tor j so gedreht wird, dass für eine erste Phaseneinstellung der Betrag $|a_i|$ der hinlaufenden Welle $a_i$ des Tors i und für eine zweite Phaseneinstellung der Betrag $|a_j|$ der hinlaufenden Welle $a_j$ des Tors j maximal wird, und wobei in beiden Phaseneinstellungen $\varphi_i$ um 180° gedreht wird, so dass der jeweilige Betrag $|a_i|$ bzw. $|a_j|$ minimal wird und so aus den Maxima und Minima von $|a_i|$ und $|a_j|$ die Beträge der Teilvektoren ($q_{01}$, $q_{02}$) und aus der Phasendifferenz zwischen den beiden Einstellungen deren Phasen bestimmt werden.

2. Verfahren nach Anspruch 1, wobei die Phasenänderung durch Versatz der Frequenz zumindest eines Signalgenerators (401, 402) um eine definierte Schrittweite während eines definierten Zeitintervalls erfolgt.

3. Verfahren nach einem der Ansprüche 1 oder 2, wobei die Messtore (405, 406) des Netzwerkanalysators (VNA) nicht über das Messobjekt (MO) miteinander verkoppelt sind, so dass die notwendigen Amplituden- und Phasenänderungen der Signalgeneratoren (401, 402) unmittelbar den Abweichungen der Amplituden und Phasen der unsymmetrischen, zum Messobjekt (MO) hinlaufenden Wellen ($a_1$, $a_2$) von den gewünschten Amplituden und Phasen entsprechen.

4. Verfahren nach einem der Ansprüche 1 bis 3, wobei die Genauigkeit der gefundenen Lösung durch Linearisierung in Abhängigkeit von den Amplituden und Phasen der Signalgeneratoren (401, 402) und Variation mittel linearen Störungsansätzen verbessert wird.

5. Verfahren nach einem der Ansprüche 1 bis 4, wobei die Verfahrensschritte iterativ wiederholt werden.

6. Verfahren nach einem der Ansprüche 1 bis 5, wobei die physikalischen Größen, für die die definierten Amplituden- und Phasenbedingungen gelten, Spannungen der zum Messobjekt (MO) hinlaufenden Wellen sind.

**7.** Verfahren nach einem der Ansprüche 1 bis 6,
wobei die Torgruppen jeweils ein Tor oder zwei Tore umfassen und die definierten Amplituden- und Phasenbedingungen im Falle einer Zweitorgruppe mit zwei Toren die eines Gleich- oder Gegentaktsignals oder einer Linearkombination hiervon sind.

**8.** Verfahren nach einem der Ansprüche 1 bis 7,
wobei ein m unsymmetrische Tore aufweisendes Mehrtor-messobjekt (MO) mit m verschiedenen Stimuluszuständen angeregt wird,
wobei jede Torgruppe aus p unsymmetrischen Toren mit jeweils p unterschiedlichen Stimuluszuständen angeregt wird und
wobei die p hinlaufenden Wellen oder Spannungen dieser Torgruppe in jedem Stimuluszustand unterschiedliche relative Amplituden- und Phasenbeziehungen aufweisen.

**9.** Verfahren nach Anspruch 8,
wobei die p verschiedenen Stimuluszustände einer Torgruppe p verschiedenen Moden entsprechen, so dass sich über alle Torgruppen hinweg insgesamt m Moden ergeben,
wobei jeder elektrischer Betriebszustand des m-Tors eindeutig durch m-dimensionale Vektoren der hin- und rücklaufenden Wellen dieser Moden beschrieben wird und wobei nach Beaufschlagung des Mehrtor-Messobjekts (MO) mit insgesamt m verschiedenen Stimuluszuständen die resultierenden m hinlaufenden Wellenvektoren in einer ersten m*m-Matrix und die m rücklaufenden Wellenvektoren in einer zweiten m*m-Matrix zusammengefasst werden und sich aus einer beide Matrizen umfassenden Operation die Mixed-Mode-Streumatrix des Mehrtor-Messobjekts (MO) ergibt.

**10.** Verfahren nach einem der Ansprüche 1 bis 9,
wobei ein m unsymmetrische Tore aufweisendes Mehrtor-Messobjekt (MO) mit m verschiedenen Stimuluszuständen angeregt wird,
wobei die Signale der Signalgeneratoren (401, 402) in diesen Zuständen Kombinationen von unsymmetrischen Gegentakt- und/oder Gleichtaktmoden sind und
wobei jede Eintorgruppe mit nur einem Messtor mindestens in einem Zustand mit einem unsymmetrischen Signal und jede Zweitorgruppe mit zwei Messtoren mindestens in einem Zustand mit einem Gegentaktsignal und mindestens in einem Zustand mit einem Gleichtaktsignal angeregt wird.

**11.** Verfahren nach Anspruch 10,
wobei zur Bestimmung einer Mixed-Mode-Matrix des Mehrtor-Messobjekts (MO) aus den unsymmetrischen, systemfehlerkorrigierten hin- und rücklaufenden Wellen entsprechend der Anordnung von unsymmetrischen und balancierten Toren an dem Mehrtor-Messobjekt (MO) Vektoren der hin- und rücklaufenden Wellen aus unsymmetrischen, Gegentakt- und/oder Gleichtaktwellen gebildet werden, diese jeweils in Matrizen angeordnet werden und aus diesen Matrizen die Mixed-Mode-Matrix berechnet wird.

## Claims

**1.** Method for stimulation and measurement of groups of ports of a multiport measurement object (MO) by means of a vector network analyser (VNA), wherein the groups of ports are stimulated with equal frequency and coherent forward travelling waves ($a_1$, $a_2$) which have defined amplitude relationships and phase differences within each group of ports, wherein the network analyser (VNA) has measurement ports (405, 406) which are unbalanced to ground, and wherein the waves are generated by a signal generator (401, 402) of the vector network analyser (VNA) for each measurement port (405, 406),
wherein a system error correction of the unbalanced forward and backward travelling waves ($a_1$, $b_1$, $a_2$, $b_2$) is carried out with respect to the ports of the measurement object (MO) in order to obtain corrected waves,
these corrected waves being used to calculate the amplitude and phase changes required in order to satisfy the desired amplitude and phase conditions in the signal generators (401, 402),
wherein the measurement ports (405, 406) are coupled with one another at least within a group of ports of the measurement object (MO),
wherein firstly for each forward travelling unbalanced wave ($a_1$; $a_2$) associated with a group of ports the components whose magnitude and phase is in each case dependent on only one of the signal generators (401; 402) associated with the group of ports are determined as sub-vectors ($q_{01}$; $q_{02}$),
wherein these sub-vectors ($q_{01}$; $q_{02}$) are used to calculate the amplitude and phase changes required overall in all the signal generators associated with the group of ports as a total vector (q1, q2) in order to satisfy the desired amplitude and phase conditions,

wherein a group of ports consists of two unbalanced ports i and j of the measurement object (MO) and to determine the sub-vectors $(q_{01}; q_{02})$ the phase $\varphi_i$ of the signal generator of port i is rotated in relation to that of port j so that for a first phase setting the magnitude $|a_i|$ of the forward travelling wave $a_i$ of the port i is maximised and for a second phase setting the magnitude $|a_j|$ of the forward travelling wave $a_j$ of the port j is maximised, and

wherein in both phase settings $\varphi_i$ is rotated by 180° so that the respective magnitudes $|a_i|$ and $|a_j|$ are minimised and thus the maxima and minima of $|a_i|$ and $|a_j|$ are used to determine the magnitudes of the sub-vectors $(q_{01}; q_{02})$ and the phase difference between the two settings is used to determine the phases of these.

2.  Method according to claim 1,
    wherein the change of phase is effected by offsetting the frequency of at least one signal generator (401, 402) by a defined increment during a defined interval of time.

3.  Method according to one of claims 1 or 2,
    wherein the measurement ports (405, 406) of the network analyser (VNA) are not coupled with one another through the measurement object (MO) so that the required amplitude and phase changes in the signal generators (401, 402) correspond directly with the differences of the amplitudes and phases of the unbalanced waves $(a_1, a_2)$ travelling forward to the measurement object (MO) with respect to the desired amplitudes and phases.

4.  Method according to one of claims 1 to 3,
    wherein the accuracy of the solution found is improved by linearization dependent on the amplitudes and phases of the signal generators (401, 402) and variation by means of linear interference relationships.

5.  Method according to one of claims 1 to 4,
    wherein the method steps are repeated iteratively.

6.  Method according to one of claims 1 to 5,
    wherein the physical quantities for which the defined amplitude and phase conditions apply are voltages of the waves travelling forward to the measurement object (MO).

7.  Method according to one of claims 1 to 6,
    wherein the groups of ports each comprise one port or two ports and the defined amplitude and phase conditions in the case of a two-port group with two ports are those of a common mode or differential mode signal or of a linear combination of these.

8.  Method according to one of claims 1 to 7,
    wherein a multiport measurement object (MO) comprising m unbalanced ports is stimulated with m different stimulus states,
    wherein each group of ports comprising p unbalanced ports is stimulated with in each case p different stimulus states and
    wherein the p forward travelling waves or voltages of this group of ports have different relative amplitude and phase relationships in each stimulus state.

9.  Method according to claim 8,
    wherein the p different stimulus states of a group of ports correspond to p different modes so that there are a total of m modes over all the groups of ports,
    wherein each electrical operating state of the m ports is clearly defined by m dimensional vectors of the forward and backward travelling waves of these modes and
    wherein after actuation of the multiport measurement object (MO) with a total of m different stimulus states the resulting m forward travelling wave vectors are combined in a first m*m matrix and the m backward travelling wave vectors are combined in a second m*m matrix and the mixed mode scattering matrix of the multiport measurement object (MO) is produced from an operation comprising both matrices.

10. Method according to one of claims 1 to 9,
    wherein a multiport measurement object (MO) comprising m unbalanced ports is stimulated with m different stimulus states,
    wherein the signals of the signal generators (401, 402) in these states are combinations of unbalanced differential modes and/or common modes and

wherein each single-port group with only one measurement port is stimulated at least in one state with an unbalanced signal and each two-port group with two measurement ports is stimulated at least in one state with a differential mode signal and at least in one state with a common mode signal.

**11.** Method according to claim 10,

wherein in order to determine a mixed mode matrix of the multiport measurement object (MO) from the unbalanced, system error corrected forward and backward travelling waves according to the arrangement of unbalanced and balanced ports of the multiport measurement object (MO), vectors of the forward and backward travelling waves are formed from unbalanced, differential mode and/or common mode waves, these are arranged in matrices in each case and the mixed mode matrix is calculated from these matrices.

**Revendications**

**1.** Procédé de stimulation et de mesure de groupes de portes d'un objet à mesurer (MO) multi-portes au moyen d'un analyseur de réseau vectoriel (VNA), les groupes de portes étant stimulés par des ondes aller ($a_1$, $a_2$) cohérentes et de même fréquence, qui présentent à l'intérieur de chaque groupe de portes des rapports d'amplitude et des différences de phase définis, l'analyseur de réseau (VNA) présentant des portes de mesure (405, 406) asymétriques par rapport à la terre, et les ondes étant générées par un générateur de signal (401, 402) respectif de l'analyseur de réseau vectoriel (VNA) par porte de mesure (405, 406),

dans lequel une correction des erreurs système des ondes aller et retour ($a_1$, $b_1$, $a_2$, $b_2$) asymétriques par rapport à la terre vis-à-vis des portes de l'objet à mesurer (MO) s'effectue pour obtenir des ondes corrigées,

dans lequel les changements d'amplitude et de phase nécessaires pour répondre aux conditions d'amplitude et de phase souhaitées dans les générateurs de signal (401, 402) sont calculés à partir de ces ondes corrigées,

dans lequel les portes de mesure (405, 406) sont couplées l'une à l'autre au moins à l'intérieur d'un groupe de portes de l'objet à mesurer (MO),

dans lequel les parts dont la valeur et la phase dépendent respectivement uniquement d'un des générateurs de signal (401 ; 402) associés au groupe de portes sont tout d'abord déterminées en tant que vecteurs partiels ($q_{01}$ ; $q_{02}$) pour chaque onde ($a_1$ ; $a_2$) asymétrique aller faisant partie d'un groupe de portes,

dans lequel les changements d'amplitude et de phase de tous les générateurs de signal associés au groupe de portes, lesdits changements étant nécessaires dans leur ensemble pour répondre aux conditions d'amplitude et de phase souhaitées, sont calculés respectivement sous la forme d'un vecteur total ($q_1$, $q_2$) à partir de ces vecteurs partiels ($q_{01}$, $q_{02}$),

dans lequel un groupe de portes est constitué de deux portes asymétriques i et j de l'objet à mesurer (MO) et, pour déterminer les vecteurs partiels ($q_{01}$, $q_{02}$), la phase $\varphi_i$ du générateur de signal de la porte i est amenée en rotation par rapport à celle de la porte j, de sorte que pour un premier réglage de phase, la valeur $|a_i|$ de l'onde aller $a_i$ de la porte i devient maximale et, pour un deuxième réglage de phase, la valeur $|a_j|$ de l'onde aller de la porte j devient maximale, et

dans lequel dans les deux réglages de phase, $\varphi_i$ est amené en rotation de 180°, de sorte que la valeur $|a_i|$ ou $|a_j|$ respective devient minimale et ainsi les valeurs des vecteurs partiels ($q_{01}$, $q_{02}$) sont déterminées à partir des maxima et des minima de $|a_i|$ et $|a_j|$ et leurs phases sont déterminées à partir de la différence de phase entre les deux réglages.

**2.** Procédé selon la revendication 1,

dans lequel la modification de phase s'effectue par décalage de la fréquence d'au moins un générateur de signal (401, 402) d'un incrément défini pendant un intervalle de temps défini.

**3.** Procédé selon l'une quelconque des revendications 1 ou 2,

dans lequel les portes de mesure (405, 406) de l'analyseur de réseau (VNA) ne sont pas couplées l'une à l'autre par l'intermédiaire de l'objet à mesurer (MO), de sorte que les changements d'amplitude et de phase nécessaires des générateurs de signal (401, 402) correspondent directement aux écarts entre les amplitudes et les phases des ondes ($a_1$, $a_2$) asymétriques, allant vers l'objet à mesurer (MO), et les amplitudes et les phases souhaitées.

**4.** Procédé selon l'une quelconque des revendications 1 à 3,

dans lequel la précision de la solution trouvée est améliorée par linéarisation en fonction des amplitudes et des phases des générateurs de phase (401, 402) et par variation au moyen de mises en équations linéaires par perturbation.

**5.** Procédé selon l'une quelconque des revendications 1 à 4,
dans lequel les étapes de procédé sont répétées par itération.

**6.** Procédé selon l'une quelconque des revendications 1 à 5,
dans lequel les grandeurs physiques, pour lesquelles les conditions d'amplitude et de phase définies s'appliquent, sont les tensions des ondes allant vers l'objet à mesurer (MO).

**7.** Procédé selon l'une quelconque des revendications 1 à 6,
dans lequel les groupes de portes comportent respectivement une porte ou deux portes et les conditions d'amplitude et de phase définies, dans le cas d'un groupe bi-porte à deux portes, sont celles d'un signal à mode commun ou différentiel ou d'une combinaison linéaire de celui-ci.

**8.** Procédé selon l'une quelconque des revendications 1 à 7,
dans lequel un objet à mesurer (MO) multi-portes présentant m portes asymétriques est stimulé par m états de stimulus différents,
dans lequel chaque groupe de portes composé de p portes asymétriques est stimulé par respectivement p états de stimulus différents et
dans lequel les p ondes aller ou tensions de ce groupe de portes présentent dans chaque état de stimulus différentes relations d'amplitude et de phase relatives.

**9.** Procédé selon la revendication 8,
dans lequel les p états de stimulus différents d'un groupe de portes correspondent à p modes différents, de sorte qu'au total m modes sont produits sur toute l'étendue de tous les groupes de portes,
dans lequel chaque état de fonctionnement électrique de la m porte est décrit clairement par des vecteurs m-dimensionnels des ondes aller et retour de ces modes et
dans lequel une fois l'objet à mesurer (MO) multi-portes sollicité par au total m états de stimulus différents, les m vecteurs d'ondes aller résultants sont regroupés dans une première m*m matrice et les m vecteurs d'ondes retour sont regroupés dans une deuxième m*m matrice et la matrice de diffusion en mode mixte de l'objet à mesurer (MO) multi-portes résulte d'une opération comportant les deux matrices.

**10.** Procédé selon l'une quelconque des revendications 1 à 9,
dans lequel un objet à mesurer (MO) multi-portes présentant m portes asymétriques est stimulé par m états de stimulus différents,
dans lequel les signaux des générateurs de signal (401, 402) sont dans ces états des combinaisons de modes communs et/ou différentiels asymétriques et
dans lequel chaque groupe mono-porte ne présentant qu'une porte de mesure est stimulé au moins dans un état par un signal asymétrique et chaque groupe bi-porte présentant deux portes de mesure est stimulé au moins dans un état par un signal à mode différentiel et au moins dans un état par un signal à mode commun.

**11.** Procédé selon la revendication 10,
dans lequel pour la détermination d'une matrice en mode mixte de l'objet à mesurer (MO) multi-portes à partir des ondes asymétriques aller et retour dont les erreurs système ont été corrigées, conformément à l'agencement des portes asymétriques et équilibrées sur l'objet à mesurer (MO) multi-portes, les vecteurs des ondes aller et retour sont formés d'ondes asymétriques à mode commun et/ou à mode différentiel, celles-ci sont agencées respectivement dans des matrices et la matrice en mode mixte est calculée à partir de ces matrices.

## Fig. 1
(Stand der Technik)

## Fig. 2

Fig. 3

Fig. 4

Fig. 7

Unkorrigiert

Amplitude und
Phase korrigiert

$A = 1.5\,dB \quad \Delta\phi = 158.2°$

----- $U_1$

——— $U_2$

$A = -0.4\,dB \quad \Delta\phi = 180.0°$

Fig. 5

t

Fig. 6

Unkorrigiert

Amplitude und
Phase korrigiert

0

0

A = 2.3 dB    $\Delta\phi$ = 77.4°

----- $U_1$

——— $U_2$

A = -3.5 dB  $\Delta\phi$ = -148.4°

Fig. 8

Fig. 9

t

Fig. 10a

Fig. 10b

Fig. 11a

Fig. 11b

Fig. 12a

Fig. 12b

Maximum von $|U_2|$

$U_{01,2}, U_{k1,2} @ |U_2|_{max}$

$A = 1.2\,dB \quad \Delta\phi = 10.5°$

$A = 1.2\,dB \quad \Delta\phi = 10.5°$

---- $U_1, U_{01}, U_{k1}$

—— $U_2, U_{02}, U_{k2}$

nach Hauptkorrektur

nach Nachkorrektur

$A = -0.3\,dB \quad \Delta\phi = 178.9°$

$A = 0.2\,dB \quad \Delta\phi = -179.7°$

Fig. 13

Fig. 14

**IN DER BESCHREIBUNG AUFGEFÜHRTE DOKUMENTE**

**In der Beschreibung aufgeführte Patentdokumente**

- US 20040201383 A1
- US 5495173 B1
- US 20040196083 A1
- US 20040196051 A1
- DE 10357243 A1
- DE 3512795 C2
- DE 19918960 B4
- DE 19918697 A1

**In der Beschreibung aufgeführte Nicht-Patentliteratur**

- **FACHAUFSATZ D.E. BOCKELMAN ; W.R. EISEN-STADT.** Combined Differential and Common-Mode Scattering Parameters: Theory and Simulation. *IEEE Transactions on Microwave Theory and Techniques,* Juli 1995, vol. 43 (7), 1530-1539
- **FACHAUFSATZ D.E. BOCKELMAN ; W.R. EISEN-STADT.** Calibration and Verification of the Pure-Mode Vector Network Analyzer. *IEEE Transactions on Microwave Theory and Techniques,* Juli 1998, vol. 46 (7), 1009-1012